# EUROPÄISCHE PATENTSCHRIFT

(11) **EP 1 360 768 B1**
(45) Veröffentlichungstag und Bekanntmachung des Hinweises auf die Patenterteilung: **20.10.2004**
(21) Anmeldenummer: 02703489.1
(22) Anmeldetag: 10.01.2002
(51) Int. Cl.: H03M 3/00

(54) **SIGMA-DELTA PROGRAMMIEREINRICHTUNG FÜR PLL-FREQUENZSYNTHESIZER**
SIGMA-DELTA PROGRAMMING DEVICE FOR A PLL-FREQUENCY SYNTHESIZER
DISPOSITIF DE PROGRAMMATION SIGMA-DELTA POUR SYNTHETISEUR DE FREQUENCE PLL

(30) Priorität: 05.02.2001 DE 10105057
(43) Veröffentlichungstag der Anmeldung: 12.11.2003
(73) Patentinhaber: Infineon Technologies AG, 81669 München (DE)
(72) Erfinder: HAMMES, Markus, 46539 Dinslaken (DE); VAN WAASEN, Stefan, 47178 Duisburg (DE)
(74) Vertreter: Lange, Thomas, Dr.
(86) Internationale Anmeldenummer: PCT/DE2002/000062
(87) Internationale Veröffentlichungsnummer: WO 2002/063772

(56) Entgegenhaltungen:
- EP-A- 0 202 347
- DE-A- 19 640 072
- DE-A- 19 929 167
- US-A- 5 903 194

## Beschreibung

Die Erfindung betrifft eine Sigma-Delta Programmiereinrichtung, einen PLL-Frequenzsynthesizer und ein Programmierverfahren unter Verwendung einer Sigma-Delta Programmiereinrichtung.

Sigma-Delta Modulatoren sind in der Digitaltechnik bekannt. Aufgrund ihrer Übertragungscharakteristik (Allpassfilter für das Eingangssignal, Hochpassfilter für das Quantisierungsrauschen) werden sie in Verbindung mit einem programmierbaren Frequenzteiler für die direkte oder indirekte Modulation eines analogen Sendesignals benutzt. Diese Techniken weisen einen weiten Anwendungsbereich auf und kommen z.B. im DECT (Digital European Communications Transmission) Standard oder bei Bluetooth-Systemen zum Einsatz.

Bei der indirekten Modulation wird eine PLL-(Phase Locked Loop: Nachlaufsynchronisations-)Schaltung als Modulator eingesetzt. PLL-Schaltungen weisen eine große Flexibilität bezüglich einsetzbarer Referenzfrequenzen bei einer geforderten Frequenzauflösung am Ausgang der PLL-Schaltung auf und bieten kurze Einschwingdauern. Die Modulation wird über einen im Rückkoppelzweig der PLL-Schaltung angeordneten programmierbare Frequenzteiler vorgenommen, welcher von einer Programmiereinrichtung gemäß einem Modulationssignal angesteuert bzw. programmiert wird. Vorzugsweise kommen sogenannte Fraktional-N PLL-Schaltungen zum Einsatz. Fraktional-N PLL-Schaltungen ermöglichen eine Frequenzteilung durch N, wobei N nicht notwendigerweise ein ganze Zahl sein muß (sogenannte fraktionale Synthesetechnik). Bei der fraktionalen Synthesetechnik werden die bei einer ganzzahligen Teilung in einem PLL auftretenden Störungen durch Seitenlinien im Spektrum umgangen.

Es sind bereits Programmiereinrichtungen für Fraktional-N PLL-Schaltungen bekannt, die einen Sigma-Delta Modulator enthalten.

Die U.S.-Patentschrift 5,903,194 offenbart eine Sigma-Delta Programmiereinrichtung, mit
- einem Eingang, welchem ein digitales Signal einer Wortbreite von N Bit zugeführt wird, wobei die höchstwertigen L Bits eines Datenwortes des Signals die Vorkommastellen der von dem Datenwort dargestellten Dualzahl und die restlichen N-L niederwertigen Bits die Nachkommastellen der Dualzahl repräsentieren,
- einem Sigma-Delta Modulator; und
- einem Addierer mit zwei Addierereingängen und einem Ausgang, wobei der Addierer an seinem zweiten Addierereingang ein von dem Sigma-Delta Modulator verarbeitetes Signal empfängt.

In der U.S.-Patentschrift 4,965,531 ist ein Fraktional-N PLL-Frequenzsynthesizer beschrieben. Die fraktionale Frequenzteilung wird durch einen Ein-Bit-Sigma-Delta Programmierer zweiter oder höherer Ordnung bewirkt, welcher einen einstufigen Zwei-Modulus-Frequenzteiler oder, in einem anderen Ausführungsbeispiel, einen zweistufigen Multi-Modulus-Frequenzteiler ansteuert. Ferner ist in der Schrift erwähnt, daß der Sigma-Delta Programmierer auch einen Mehr-Bit-Ausgang aufweisen kann.

In der U.S.-Patentschrift 6,008,703 ist ein weiterer Fraktional-N PLL-Frequenzsynthesizer angegeben. Der Schaltkreis umfaßt einen fraktionalen Frequenzteiler, welcher aus einem Sigma-Delta-Modualtor als Programmiereinrichtung und einem Multi-Modulus-Frequenzteiler in der Rückkoppelschleife der PLL-Schaltung besteht. Der Sigma-Delta-Modulator erzeugt ein Teilersignal einer Wortbreite von sechs Bit. Der Multi-Modulus-Frequenzteiler besteht aus einer Multi-Modulus-4/5/6/7-Teilerstufe mit einem Eingang für zwei Bits und vier kaskadierten 2/3-Teilerstufen, die jeweils einen Ein-Bit-Eingang aufweisen. Auf diese Weise ist eine Frequenzteilung erreichbar, die einem "Schlucken" einer Anzahl von 0 bis 63 Perioden (2π) des Ausgangssignals des spannungsgesteuerten Oszillators entspricht (Pulse-Swallowing-Prinzip).

In der Offenlegungsschrift DE 199 29 167 A1 ist eine Zwei-Punkt-Modulation mittels einer PLL-Schaltung beschrieben. Die Modulation wird zum einen über einen Sigma-Delta Fraktional-N Frequenzteiler im Rückkoppelzweig der Schaltung und zum anderen über das Einspeisen des (zuvor einer Analogwandlung unterzogenen) Modualtionssignals an einem Summationspunkt am Eingang des spannungsgesteuerten Oszillators vorgenommen.

In der U.S.-Patentschrift 6,044,124 ist eine Sigma-Delta Programmiereinrichtung für einen programmierbaren Frequenzteiler beschrieben. Die Sigma-Delta Programmiereinrichtung umfaßt eine Einheit bestehend aus einem Sigma-Delta Modulator, einem Dither-Funktionsmodulator und einen von dem Ausgangssignal des Dither-Funktionsmodulators gesteuerten Schalter, welcher ein Steuersignal für den fraktionalen Anteil der Frequenzteilung liefert. Ein Addierer addiert dieses Steuersignal für den fraktionalen Anteil der Frequenzteilung mit einem Steuersignal für den ganzzahligen Teileranteil. Das Ausgangssignal des Addierers wird zur Programmierung des programmierbaren Frequenzteilers eingesetzt.

Das frequenzbegrenzende Element einer solchen PLL-Schaltung ist der Frequenzteiler. Dies gilt insbesondere dann, wenn der Frequenzteiler als integriertes Bauteil in einem reinen CMOS-Prozeß realisiert ist. Dabei ist zu beachten, daß in bezug auf die Frequenzbegrenzung die Verwendung ungerader Teilerfaktoren (Divisoren) zur Programmierung des Frequenzteilers wesentlich kritischer ist als die Verwendung gerader Divisoren. Daher wird angestrebt, das Auftreten ungerader Divisoren zur Ansteuerung eines programmierbaren Frequenzteilers zu vermeiden. Bisher gelingt die Erzeugung von ausschließlich geraden Divisoren nur dann, wenn die Programmiereinrichtung zur Ansteuerung des Frequenzteilers aus kompliziert aufgebauten Multibit-Sigma-Delta Modulatoren bestehend aus einem Komparator mit mehreren Entscheiderschwellen aufgebaut ist. Dies macht einen hohen Design- und Fertigungsaufwand erforderlich.

Der Erfindung liegt die Aufgabe zugrunde, eine Sigma-Delta Programmiereinrichtung sowie ein Programmierverfahren zu schaffen, welche bzw. welches in einfacher Weise nur gerade Ausgangswerte (Divisoren) für die Programmierung einer Einrichtung wie z.B. einen programmierbaren Frequenzteiler erzeugt. Darüber hinaus zielt die Erfindung auch darauf ab, einfach aufgebaute Anordnungen für direkte und indirekte Modulatoren anzugeben.

Die Erfindung wird durch die Merkmale der unabhängigen Ansprüche gelöst.

Dadurch, daß dem Sigma-Delta Modulator neben den N-L niederwertigen Bits, welche die Nachkommastellen des Datenwortes des Modulationssignals repräsentieren, auch das Bit der niederwertigsten Vorkommastelle dieses Datenworts zugeleitet wird, wird eine Rechtsverschiebung des ganzzahligen Anteils des Datenwortes um eine Binärstelle und damit eine Muliplikation desselben mit dem Faktor 0,5 erreicht. Die Auflösung des Sigma-Delta Modulators muß aufgrund der einen zusätzlichen Stelle um ein Bit größer als bei einem Sigma-Delta Modulator gemäß herkömmlicher Implementierung sein. Nach der Addition des um eine Stelle nach rechts verschobenen (und um sein niederwertigstes Bit verkürzten) ganzzahligen Anteils des Datenwortes mit dem Ausgang des Sigma-Delta Modulators im Addierer erfolgt eine Multiplikation mit dem Wert 2. Dadurch wird das Datenwort wieder in den korrekten Wertebereich umgesetzt und außerdem wird auf diese Weise gewährleistet, daß der am Ausgang des Multiplizierers gelieferte Divisor stets eine gerade ganze Zahl ist.

Vorzugsweise handelt es sich bei dem Sigma-Delta Modulator um einen Sigma-Delta Modulator, der ausschließlich aus Einzel-Bit Entscheidern (einem Komparator mit nur einer Entscheiderschwelle) aufgebaut ist. Auf diese Weise wird ein minimaler Entwurfs- und Realisierungsaufwand für die Sigma-Delta Programmiereinrichtung erzielt.

Eine bevorzugte Anwendung der erfindungsgemäßen Sigma-Delta Programmiereinrichtung ist die Verwendung zur Ansteuerung eines programmierbaren Frequenzteilers, welcher sich in der Rückkoppelschleife einer PLL-Schaltung befindet. Auf diese Weise wird gewährleistet, daß für die fraktionale Frequenzteilung zu jedem Zeitpunkt geradzahlige Divisorwerte (die Ausgangswerte der Sigma-Delta Programmiereinrichtung) eingesetzt werden. Der gemäß der Erfindung hierfür erforderliche Zusatzaufwand (Sigma-Delta Modulator mit um ein Bit erhöhter Auflösung, zusätzlicher Multiplizierer) ist gering.

Weitere vorteilhafte Ausgestaltungen der Erfindung sind in den Unteransprüchen angegeben.

Die Erfindung wird nachfolgend anhand eines Ausführungsbeispiels unter Bezugnahme auf die Zeichnung beschrieben; in dieser zeigt:
- Fig. 1: ein Blockschaltbild zur Erläuterung einer erfindungsgemäßen Fraktional-N PLL-Schaltung;
- Fig. 2: ein Blockschaltbild zur Erläuterung einer Sigma-Delta Programmiereinrichtung nach dem Stand der Technik;
- Fig. 3: ein Blockschaltbild zur Erläuterung einer Sigma-Delta Programmiereinrichtung nach der Erfindung.

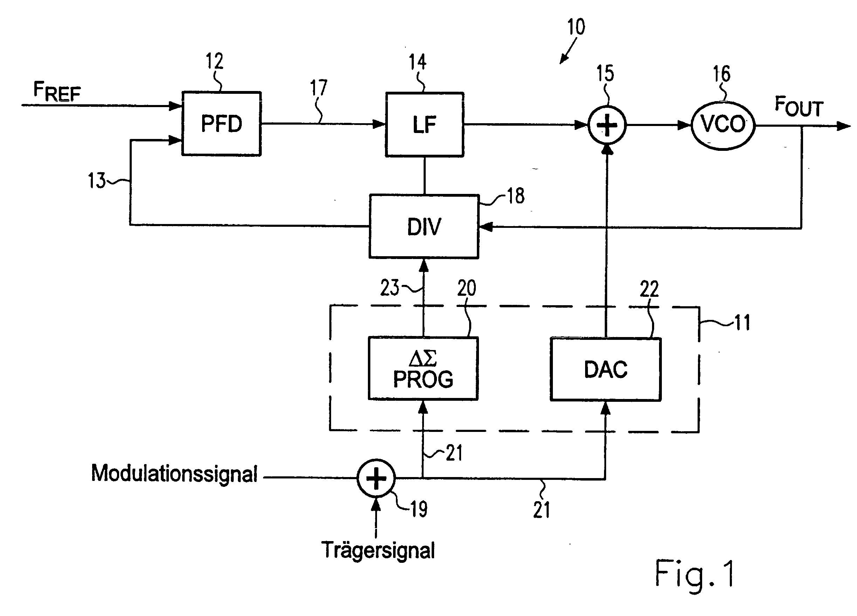

Fig. 1 zeigt einen Frequenzsynthesizer, mit welchem ein Ausgangssignal einer Frequenz F_{OUT} aus einem Eingangs- oder Referenzsignal der Frequenz F_{REF} hergestellt wird. Das Ausgangssignal der Frequenz F_{OUT} ist durch ein digitales Modualtionssignal modulierbar.

Der Frequenzsynthesizer umfaßt eine PLL-Schaltung 10 und eine an geeigneten Punkten mit der PLL-Schaltung 10 gekoppelte Schaltung 11, mittels welcher eine Modulation des Ausgangssignals der PLL-Schaltung 10 vorgenommen wird.

Die PLL-Schaltung 10 weist einen Phasendetektor PFD (Phase-Frequency-Detector) 12 auf, dem das Referenzsignal der festen Frequenz F_{REF} sowie ein rückgekoppeltes Frequenzteilersignal 13 zugeführt wird. Das Referenzsignal wird beispielsweise von einem Schwingquarz abgeleitet. Der Phasendetektor 12 vergleicht die Phasen der beiden erhaltenen Frequenzen und erzeugt ein Steuersignal 17, welches der Phasendifferenz der beiden erhaltenen Signale entspricht. Das Steuersignal 17 wird einem Schleifenfilter LF (Loop Filter) 14 zugeführt, welches ein Tiefpassfilter ist und das Steuersignal 17 glättet. Der Ausgang des Schleifenfilters 14 durchläuft einen optionalen Summationspunkt 15 (welcher lediglich bei einer Zwei-Punkt-Modulation vorhanden ist) und wird einem spannungsgesteuerten Oszillator VCO (Voltage Controlled Oscillator) 16 eingespeist. Der Ausgang des spannungsgesteuerten Oszillators 16 liefert einerseits das Ausgangssignal der PLL-Schaltung 10 und wird andererseits über einen programmierbaren Frequenzteiler DIV 18 dem Frequenzdetektor 12 als Frequenzteilersignal 13 zurückgeführt. Der programmierbare Frequenzteiler 18 ist üblicherweise als Multi-Modulus Frequenzteiler (Multimodulus Frequency Divider) ausgeführt.

Die Wirkungsweise der PLL-Regelschleife 10 ist derart, daß die Frequenz F_{OUT} des Ausgangssignals der Regelschleife 10 im Gleichgewichtszustand exakt dem durch den Frequenzteiler 18 festgelegten Vielfachen der Referenzfrequenz F_{REF} entspricht.

Das der PLL-Frequenzsynthese zugrunde liegende Trägersignal sowie das digitale Modulationssignal zur Trägermodulation werden in bekannter Weise über die Schaltung 11 und den programmierbaren Frequenzteiler 18 in die PLL-Schaltung 10 eingespeist. Hierfür wird das digitale Modulationssignal über einen Summationspunkt 19 dem Trägersignal hinzuaddiert. Das sich ergebende modulierte Trägersignal 21 wird einem Sigma-Delta Programmierer (ΔΣ PROG) 20 in Form einer Folge aufeinanderfolgender Frequenzwörter eingespeist. Der Sigma-Delta Programmierer 20 erzeugt ein Divisor-Steuersignal 23 für den programmierbaren Frequenzteiler 18. Das Divisor-Steuersignal 23 besteht aus einer Folge von Datenworten. Jedes Datenwort repräsentiert eine ganze Zahl. Bei Erhalt eines jeden Datenwortes wird der Frequenzteiler 18 so programmiert, daß er die erhaltene Frequenz Fₒᵤₜ mit dem Kehrwert der ganzen Zahl multipliziert.

Das Einbringen der Modulation über den programmierbaren Frequenzteiler 18 in die PLL-Schaltung 10 bewertet das Modulationssignal mit einer Tiefpassfunktion. Dadurch wird die Modulationsbandbreite im allgemeinen auf Bandbreiternwerte eingeschränkt, die kleiner als die PLL-Bandbreite sind. Um ein im wesentlichen frequenzunabhängiges Übertragungsverhalten der PLL-Schaltung 10 zu erzielen, wird in optionaler Weise die 2-Punkt-Modualtionstechnik eingesetzt. Bei dieser Technik wird das modulierte Trägersignal 21 einem Digital-Analog-Wandler DAC (Digital Analog Converter) 22 zugeleitet. Dieser setzt das modulierte Trägersignal 21 in ein analoges Signal um, welches an einem Punkt mit Hochpass-Charakteristik in die PLL-Schaltung 10 eingespeist wird.

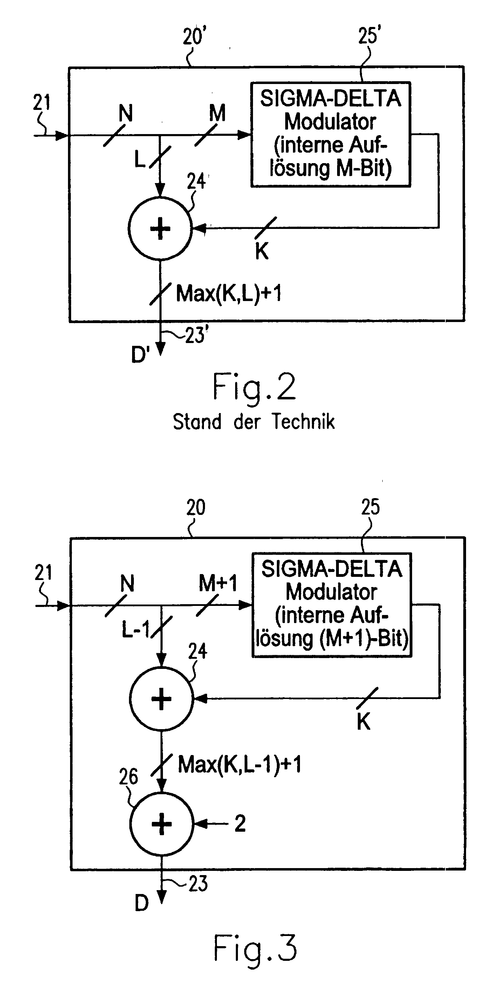

Die Verwendung einer Sigma-Delta Programmiereinrichtung zur Ansteuerung eines Multi-Modulus Frequenzteilers ist im Stand der Technik bekannt, siehe z.B. die eingangs erwähnte U.S.-Patentschrift 6,044,124. Durch die Verwendung eines Sigma-Delta Modulators in der Programmiereinrichtung können sehr feine Quantisierungsstufen der eingebrachten Phase des modulierten Trägersignals 21 erreicht werden. Fig. 2 verdeutlicht den Aufbau eines bekannten Sigma-Delta Programmierers 20'. Eingangsseitig 21 wird dem bekannten Sigma-Delta Programmierer 20' ein Frequenzwort zugeleitet, welches eine Wortbreite von N Bit aufweist. In dem Programmierer 20' wird nun der rationale Anteil (M-Bit) des N-Bit Frequenzwortes einem Sigma-Delta Modulator 25' zugeführt. Die M Bit repräsentieren die Nachkommastellen des Frequenzwortes, d.h. sind den Wertigkeiten 2⁻¹, 2⁻², 2⁻³, ..., usw. zugeordnet. Die Vorkommastellen, das heißt der ganzzahlige Anteil des Frequenzwortes, umfaßt die restlichen L=N-M Bit. Dieser ganzzahlige Anteil wird von dem N-Bit Frequenzwort abgetrennt und einem Addierer 24 zugeleitet. Der andere Eingang des Addierers 24 wird von dem Ausgang des Sigma-Delta Modulators 25' gespeist. Der Sigma-Delta Modulator 25' weist eine interne Auflösung von M-Bit auf und gibt ein Ausgabesignal einer Wortbreite von K Bit aus. Das K-Bit Binärwort repräsentiert eine ganze Zahl.

Der Addierer 24 berechnet aus den erhaltenen Bitworten eine ganze Zahl D'. Aufgrund der Addition erhöht sich die Wortbreite des Ausgangssignals des Addierers 24 auf Max(K,L)+1. Bei der Addition können im allgemeinen sowohl gerade als auch ungerade ganze Zahlen D' als Ergebnis entstehen. Dies hat zur Folge, daß der programmierbare Frequenzteiler 18, welcher von dem Ausgangssignal 23' des Addierers 24 angesteuert und in ständiger Wiederholung umprogrammiert wird, eine Frequenzteilung mit einem geraden oder einem ungeraden Divisor D' vornimmt. ,

Fig. 3 zeigt den Aufbau eines erfindungsgemäßen Sigma-Delta Programmierers 20. Dieselben oder vergleichbare Funktionselemente wie in Fig. 2 sind mit denselben Bezugszeichen gekennzeichnet. Bei dem erfindungsgemäßen Sigma-Delta Programmierer 20 handelt es sich ebenfalls um einen digitalen Mehr-Bit-Programmierer. Analog zum Stand der Technik wird diesem das modulierte Trägersignal 21 in Form einer Folge von N-Bit Frequenzwörtern zugeleitet. Der wesentliche Unterschied zum Stand der Technik (Fig. 2) besteht nun darin, daß der Sigma-Delta Modulator 25 ein Bit mehr als den rationalen Anteil des Frequenzwortes verarbeitet. Mit anderen Worten wird das N-Bit Frequenzwort in einen ersten Anteil bestehend aus den L-1 höherwertigen Bits und einen zweiten Anteil bestehend aus den restlichen M+1 niederwertigeren Bits zerlegt. Dem Sigma-Delta Modulator 25, welcher eine interne Auflösung von M+1 Bit aufweist, wird der aus den niederwertigeren M+1 Bit bestehende Anteil des Frequenzwortes zugeleitet. Dieser Anteil wird einer Sigma-Delta Modulation unterzogen. Der höherwertigere (L-1)-Bit Anteil wird dem Addierer 24 zugeleitet, wobei das niederwertigste Bit dieses Anteils, welches die Wertigkeit 2¹ besitzt, dem Addierereingang der Wertigkeit 2° zugeführt wird, das Bit der Wertigkeit 2² dem Addierereingang der Wertigkeit 2¹ zugeführt wird, u.s.w.. Dies entspricht einer Division des ganzzahligen Anteils des Frequenzwortes durch den Wert 2 und - sofern das dabei erhaltene Ergebnis keine ganze Zahl ist (d.h. der ganzzahlige Anteil des Frequenzwortes eine ungerade Zahl ist) - einer Abrundung auf die nächst kleinere ganze Zahl.

Durch die Addition des auf diese Weise erhaltenen Bitwortes mit dem Ausgang des Sigma-Delta Modulators 25 (Wortbreite K) ergibt sich ein ganzzahliges Bitwort der Wortbreite Max(K,L-1)+1. Um eine Abbildung in den korrekten Wertebereich zu erzielen, daß heißt die Teilung durch den Wert 2 rückgängig zu machen, wird dieses Bitwort einem Multiplizierer 26 zugeführt. Dieser nimmt eine Multiplikation mit dem Faktor 2 vor, das heißt verschiebt das von dem Addierer 24 erhaltene Bitwort um eine Binärstelle noch links. Das am Ausgang des Multiplizierers 26 bereitstehende Divisor-Steuersignal weist somit stets geradzahlige Werte D auf. Diese werden wie bereits erwähnt in dem programmierbaren Frequenzteiler 18 als Divisoren verwendet.

Der besondere Vorteil des erfindungsgemäßen Sigma-Delta Programmierers 20 besteht darin, daß er in sehr einfacher Weise aus dem konventionellen Sigma-Delta Programmierer 20' entwikkelt werden kann. Die gesamte Peripherie zur Erzeugung des modulierten Trägersignals 21 (Frequenzeingangswort) sowie die Architektur des verwendeten Sigma-Delta Programmierers bleiben unverändert. Es muss lediglich die Auflösung des Sigma-Delta Modulators 25 um ein Bit erweitert und am Ausgang des konventionellen Sigma-Delta Programmierers 20' ein Multiplizierer 26 hinzugefügt werden.

Durch die erfindungsgemäße Vorgehensweise wird das Rauschen in der PLL-Schaltung 10 um 6dB verschlechtert. Dies liegt darin begründet, daß aufgrund der unveränderten Ordnung und Referenzfrequenz das Rauschen im erfindungsgemäßen Sigma-Delta Programmierer 20 verglichen mit dem konventionellen Sigma-Delta Programmierer 20' bis zu der Multiplikation mit dem Faktor 2 (Multiplizierer 26) unverändert bleibt. Durch die Multiplikation verschiebt sich dann das komplette Spektrum um 6dB, so daß auch durch die Filterung in der geschlossenen PLL-Regelschleife 10 vom Einspeisepunkt des Divisors D am programmierbaren Frequenzteiler 18 zum Ausgang des spannungsgesteuerten Oszillators 16 eine Erhöhung des Rauschens um 6dB auftritt. Dieses erhöhte Rauschen kann zumindest teilweise durch eine Verringerung der Bandbreite der PLL-Schaltung 10 mittels des Schleifenfilters 14 kompensiert werden. Die dabei auftretende Vergrößerung der Einschwingzeit ist für einen Sigma-Delta Fraktional-PLL bei Systemen wie z.B. Bluetooth unkritisch.

Wie bereits erwähnt, wirken der Sigma-Delta Programmierer 20 und der programmierbare Frequenzteiler 18 in Form eines fraktionalen Frequenzteilers zusammen. Dadurch wird erreicht, daß bei der Frequenzsynthese der Quotient F_{OUT}/F_{REF} auf eine nicht ganze Zahl eingestellt werden kann, obgleich die zur Programmierung verwendeten Zahlen ganze Zahlen sind. Das Prinzip der fraktionalen Frequenzteilung ist bekannt. Sie beruht auf einer dynamische Änderung der (ganzzahligen, erfindungsgemäß auch geradzahligen) Divisorwerte D über die Zeit. Die dem Addierer 24 durch den (L-1)-Bit Anteil des Frequenzwortes zugeführte Zahl wird mit D1 und die dem Addierer 24 von dem Sigma-Delta Modulator 25 zugeführte Zahl wird mit D2 bezeichnet. Während der Summand D1 über einen Abtastzeitraum konstant bleibt und den ganzzahligen Anteil der fraktionalen Division vorgibt, wird der Summand D2 mittels der Sigma-Delta Modulation in Überabtastung verarbeitet und daher ständig geändert. Der Mittelwert der Werte von D2 gibt dann den fraktionalen Anteil der Frequenzteilung vor.

Der erfindungsgemäße Sigma-Delta Programmierer 20 kann auch für eine direkte Modulation verwendet werden. Die direkte Modulation unterscheidet sich von der anhand Fig. 1 erläuterten indirekten Modulation im wesentlichen nur dadurch, daß die PLL-Schaltung 10 entfällt. Das heißt, der von dem programmierbaren Frequenzteiler 18 realisierte Einspeisepunkt liegt bei der direkten Modulation nicht in einer Rückkoppelschleife sondern direkt im Signalpfad der zu modulierenden Referenzfrequenz.

## Patentansprüche

1. Sigma-Delta Programmiereinrichtung, mit
- einem Eingang, welchem ein digitales Signal (21) einer Wortbreite von N Bit zugeführt wird, wobei die höchstwertigen L Bits eines Datenwortes des Signals (21) die Vorkommastellen der von dem Datenwort dargestellten Dualzahl und die restlichen N-L niederwertigen Bits die Nachkommastellen der Dualzahl repräsentieren,
- einem Sigma-Delta Modulator (25), welchem die N-L+1 niederwertigen Bits des N-Bit Datenwortes zugeleitet werden,
- einem Addierer (24), welcher an seinem einen Addierereingang die L-1 höchstwertigen Bits des N-Bit Datenwortes entgegennimmt und an seinem anderen Addierereingang ein von dem Sigma-Delta Modulator (25) verarbeitetes Signal empfängt, und
- einem Multiplizierer (26), welcher den Ausgang des Addierers (24) mit dem Wert 2 multipliziert.

2. Sigma-Delta Programmiereinrichtung nach Anspruch 1,
**dadurch gekennzeichnet,**
- **daß** der Sigma-Delta Modulator (25) ausschließlich aus Einzel-Bit Entscheidern aufgebaut ist.

3. Anordnung aus einer Sigma-Delta Programmiereinrichtung (20) nach einem der vorhergehenden Ansprüche und einem programmierbaren Frequenzteiler (18), welcher von der Sigma-Delta Programmiereinrichtung (20) angesteuert wird.

4. PLL-Frequenzsynthesizer, welcher eine Sigma-Delta Programmiereinrichtung (20) nach Anspruch 1 oder 2 sowie eine PLL-Schaltung (10) umfaßt,
**dadurch gekennzeichnet,**
**daß** die PLL-Schaltung (10) aufweist:
- einen spannungsgesteuerten Oszillator (16) mit einem Ausgang, an welchem ein phasen- oder frequenzmoduliertes Ausgangssignal ausgegeben wird,
- einen Phasendetektor (12), welcher eine Phasendifferenz zwischen einem von dem Ausgangssignal abgeleiteten Rückkoppelsignal und einem Referenzsignal ermittelt und in Abhängigkeit von der ermittelten Phasendifferenz den spannungsgesteuerten Oszillator (16) ansteuert, und
- einer das Rückkoppelsignal bereitstellenden Rückkoppelschleife, welche einen programmierbaren Frequenzteiler (18) umfaßt, welcher von der Sigma-Delta Programmiereinrichtung (20) gesteuert wird.

5. Anordnung nach Anspruch 4,
**gekennzeichnet durch**
- einen D/A-Umsetzer (22), dem das digitale Signal zugeleitet wird und dessen Ausgang mit einem Punkt der PLL-Schaltung mit Hochpaß-Übertragungsverhalten in die PLL-Schaltung (10) verbunden ist.

6. Verfahren zum Programmieren einer programmierbaren Einrichtung, insbesondere Frequenzteiler (18), mittels einer Sigma-Delta Programmiereinrichtung, mit den Schritten:
- Eingeben eines digitalen Signals (21) einer Wortbreite von N-Bit in die Sigma-Delta Programmiereinrichtung (20), wobei die höchstwertigen L Bits eines Datenwortes des Signals (21) die Vorkommastellen der von dem Datenwort dargestellten Dualzahl und die restlichen N-L niederwertigen Bits die Nachkommastellen der Dualzahl repräsentieren;
- Sigma-Delta Modulieren der N-L+1 niederwertigen Bits des N-Bit Datenwortes;
- Addieren der L-1 höchstwertigen Bits des N-Bit Datenwortes mit einem Datenwort des Sigma-Delta modulierten Signals;
- Multiplizieren des bei der Addition erhaltenen Datenworts mit dem Wert 2; und
- Programmieren der programmierbaren Einrichtung mit dem bei der Multiplikation erhaltenen Datenwort.

## Claims

1. Sigma-delta programming device, having
- an input to which a digital signal (21) with a word length of N bits is supplied, the most significant L bits of a data word in the signal (21) representing the places before the decimal point in the binary number represented by the data word, and the remaining N-L less significant bits representing the places after the decimal point in the binary number,
- a sigma-delta modulator (25) to which the N-L+1 less significant bits of the N-bit data word are supplied,
- an adder (24) whose first adder input receives the L-1 most significant bits of the N-bit data word and whose other adder input receives a signal processed by the sigma-delta modulator (25), and
- a multiplier (26) which multiplies the output of the adder (24) by the value 2.

2. Sigma-delta programming device according to Claim 1,
**characterized**
- **in that** the sigma-delta modulator (25) is constructed exclusively from single-bit decision makers.

3. Arrangement comprising a sigma-delta programming device (20) according to one of the preceding claims and a programmable frequency divider (18) which is actuated by the sigma-delta programming device (20).

4. PLL frequency synthesizer which comprises a sigma-delta programming device (20) according to Claim 1 or 2 and a PLL circuit (10),
**characterized**
**in that** the PLL circuit (10) has:
- a voltage-controlled oscillator (16) having an output at which a phase-modulated or frequency-modulated output signal is output,
- a phase detector (12) which ascertains a phase difference between a feedback signal, derived from the output signal, and a reference signal and takes the ascertained phase difference as a basis for actuating the voltage-controlled oscillator (16), and
- a feedback loop, providing the feedback signal, which comprises a programmable frequency divider (18) which is controlled by the sigma-delta programming device (20).

5. Arrangement according to Claim 4,
**characterized by**
- a D/A converter (22) to which the digital signal is supplied and whose output is connected to a point in the PLL circuit having a high-pass transfer response into the PLL circuit (10).

6. Method for programming a programmable device, particularly a frequency divider (18), using a sigma-delta programming device, having the following steps:
- a digital signal (21) having a word length of N bits is input into the sigma-delta programming device (20), the most significant L bits of a data word in the signal (21) representing the places before the decimal point in the binary number represented by the data word, and the remaining N-L less significant bits representing the places after the decimal point in the binary number;
- the N-L+1 less significant bits of the N-bit data word are subjected to sigma-delta modulation;
- the L-1 most significant bits of the N-bit data word are added to a data word in the sigma-delta modulated signal;
- the data word obtained from the addition is multiplied by the value 2; and
- the programmable device is programmed using the data word obtained from the multiplication.

## Revendications

1. Dispositif de programmation Sigma-Delta comprenant :
- une entrée à laquelle est envoyé un signal (21) numérique d'une largeur de mot de N bit, les L bits, les plus significatifs, d'un mot de données du signal (21) représentant les positions avant la virgule du nombre dual représenté par le mot de données et les N-L bits restants moins significatifs représentant les positions après la virgule du nombre dual,
- un modulateur (25) Sigma-Delta auquel sont envoyés les N-L+1 bits moins significatifs du mot de données à N bit,
- un additionneur (24) qui reçoit sur son entrée d'additionneur les L-1 bits les plus significatifs du mot de données à N bit et qui reçoit sur son autre entrée d'additionneur un signal traité par le modulateur (25) Sigma-Delta, et
- un multiplicateur (26) qui multiplie la sortie de l'additionneur (24) par la valeur 2.

2. Dispositif de programmation Sigma-Delta suivant la revendication 1,
**caractérisé en ce que**
le modulateur (25) Sigma-Delta est constitué exclusivement de dispositifs de décision à un seul bit.

3. Système constitué d'un dispositif (20) de programmation Sigma-Delta suivant l'une des revendications précédentes et d'un diviseur (18) de fréquence programmable, qui est commandé par le dispositif (20) de programmation Sigma-Delta.

4. Synthétiseur de fréquence (PLL) qui comprend un dispositif (20) de programmation Sigma-Delta suivant la revendication 1 ou 2 ainsi qu'un circuit (10) PLL
**caractérisé**
**en ce que** le circuit (10) PLL comporte :
- un oscillateur commandé en tension et ayant une sortie sur laquelle est émis un signal de sortie modulé en phase ou en fréquence,
- un détecteur (12) de phase, qui détermine une différence de phase entre un signal de réaction dérivé du signal de sortie et un signal de référence et qui commande, en fonction de la différence de phase déterminée, l'oscillateur (16) commandé en tension, et
- une boucle de réaction mettant à disposition le signal de réaction et comprenant un diviseur (18) de fréquence programmable qui est commandé par le dispositif (20) de programmation Sigma-Delta.

5. Synthétiseur suivant la revendication 4,
**caractérisé par**
- un convertisseur numérique/analogique auquel est envoyé le signal numérique et dont la sortie est reliée à un point du circuit (PLL) ayant un comportement de transmission passe-haut dans le circuit (10) (PLL).

6. Procédé de programmation d'un dispositif programmable, notamment d'un diviseur (18) de fréquence au moyen d'un dispositif de programmation Sigma -Delta, comprenant les stades dans lesquels :
- on entre un signal (21) numérique d'une largeur de mot de N bit dans le dispositif (20) de programmation sigma-Delta, les L bits les plus significatifs d'un mot de donnés de signal (21) représentant les points avant la virgule du nombre dual représenté par le mot de données et les N-L bits restants moins significatifs représentant les positions après la virgule du nombre dual ;
- on effectue une modulation Sigma-Delta des N-L +1 bits moins significatifs du mot de donnés à N bit ;
- on ajoute les L-1 bits les plus significatifs du mot de donnée à un mot de donnée du signal modulé Sigma-Delta ;
- on multiplie le mot de données obtenu par l'addition par la valeur 2 ; et
- on programme le dispositif programmable par le mot de données obtenu dans la multiplication.
